# EUROPÄISCHE PATENTANMELDUNG

(11) **EP 3 815 872 A1**
(43) Veröffentlichungstag der Anmeldung: **05.05.2021**
(21) Anmeldenummer: 20203003.7
(22) Anmeldetag: 21.10.2020
(51) Int. Cl.: B29C 45/14, B29C 45/73, B29C 45/00, H01L 21/56, H05K 3/28, H01L 23/29, H05K 5/00, B29C 45/77, B29C 45/78, F16H 61/00, C08K 3/013, C08L 67/06, G01D 11/24, B29K 67/00, B29K 501/12, B29K 509/02, B29L 31/34

(54) **MOLD-MODUL**

(30) Priorität: 30.10.2019 DE 102019216723
(71) Anmelder: Robert Bosch GmbH, 70442 Stuttgart (DE)
(72) Erfinder: Geise, Stephan, 59602 Ruethen (DE)

(57) **Zusammenfassung**

Erfindungsgemäß weist das Mold-Modul einen die Mold-Masse umspannenden Rahmen auf. Der Rahmen umfasst einen Thermoplast, oder ist aus einem Thermoplast gebildet. Die Mold-Masse weist einen Duroplast und eine Expansionskomponente, insbesondere einen Thermoplast auf. Die Expansionskomponente, insbesondere der Thermoplast ist in den Duroplast eingemischt oder eingebettet und ausgebildet, ein Schwinden, insbesondere eine Volumenverringerung des Duroplasts wenigstens teilweise oder vollständig zu kompensieren, und so gegen den Rahmen abzudichten.

## Beschreibung

### Stand der Technik

Die Erfindung betrifft ein Mold-Modul. Das Mold-Modul umfasst ein Halbleiterbauteil und eine Mold-Masse, wobei das Halbleiterbauteil in die Mold-Masse eingebettet ist.

Mold-Module werden durch Spritzgießen mit einem Spritzgusswerkzeug erzeugt. Die Mold-Masse wird dazu in niedrigviskoser, insbesondere teigiger Form in einen Hohlraum des Spritzgusswerkzeugs eingepresst. Das Spritzgusswerkzeug weist wenigstens zwei den Hohlraum umschließende Werkzeughälften auf. Nach einem Entformen, insbesondere einem Öffnen oder Trennen der Werkzeughälften voneinander, verbleibt an dem ausgehärteten Mold-Modul ein Grat. Der Grat, welcher an einer Trennstelle der Werkzeughälften erzeugt worden ist, kann bei einem Einbau oder einer weiteren Verwendung des Mold-Moduls stören, und muss in diesem Fall durch Schleifen oder Fräsen von dem Mold-Modul entfernt werden.

### Offenbarung der Erfindung

Erfindungsgemäß weist das Mold-Modul einen die Mold-Masse umspannenden Rahmen auf. Der Rahmen umfasst einen Thermoplast, oder ist aus einem Thermoplast gebildet. Die Mold-Masse weist einen Duroplast und eine Expansionskomponente, insbesondere einen Thermoplast auf. Die Expansionskomponente, insbesondere der Thermoplast ist in den Duroplast eingemischt oder eingebettet und ausgebildet, ein Schwinden, insbesondere eine Volumenverringerung des Duroplasts wenigstens teilweise oder vollständig zu kompensieren, und so gegen den Rahmen abzudichten.

Vorteilhaft kann die Mold-Masse so spaltfrei an den Rahmen anschließen. Der Rahmen, welcher bevorzugt aus einem Thermoplast gebildet ist, kann vorteilhaft gratfrei, oder nur mit kleinen, wenig störenden Graten ausgebildet sein. Vorteilhaft kann das Mold-Modul so - beispielsweise mit einem Gehäuse, insbesondere Getriebegehäuse - dicht verbunden werden. Weiter vorteilhaft kann durch die Spaltfreiheit des Mold-Moduls an einer Übergangsstelle zwischen der Mold-Masse und dem Thermoplastrahmen kein Medium, insbesondere Getriebeöl, in das Mold-Modul eindringen.

In einer bevorzugten Ausführungsform ist die Expansionskomponente ausgebildet, die Moldmasse mehr als das Schrumpfen des Duroplasts zu expandieren. Durch die Überkompensation des Schrumpfens kann so vorteilhaft eine Spannung in dem Thermoplastrahmen gebildet werden, die die Grenzfläche zwischen der Moldmasse und dem Thermoplastrahmen auch bei Temperaturwechselbelastung dicht hält.

In einer bevorzugten Ausführungsform des Mold-Moduls ist die Expansionskomponente, bevorzugt Thermoplastkomponente, in dem Duroplast insbesondere homogen verteilt. Weiter bevorzugt bildet der Duroplast ein Matrixmaterial der Mold-Masse. Vorteilhaft kann ein Schrumpfen des Duroplasts so beim Erzeugen des Mold-Moduls gleichmäßig über sein Volumen verteilt kompensiert werden.

In einer bevorzugten Ausführungsform sind in der Mold-Masse als Expansionskomponente Thermoplastpartikel oder Thermoplastfasern eingebettet. Die Mold-Masse kann so aufwandsgünstig bereitgestellt werden. In einer bevorzugten Ausführungsform ist der in der Mold-Masse eingebettete oder verteilte Thermoplast Styrol oder Polystyrol. Vorteilhaft kann der Thermoplast so aufwandsgünstig dem Duroplast in einer flüssigen Form beigemischt werden. Bevorzugt ist der Duroplast durch ein Harz, insbesondere ein ungesättigtes Polyester-Harz, gebildet.

Es wurde nämlich erkannt, dass sich der Thermoplast während eines fortschreitenden Vernetzungsvorgangs des Duroplasts, insbesondere des Harzes, als disperse Phase abscheiden kann, und so bevorzugt insbesondere monomeres Styrol einschließen kann, oder in gelöster Form enthalten kann. Das Styrol kann so beim Aushärten des Duroplasts eine während des Aushärtens des Duroplasts freiwerdende Reaktionswärme aufnehmen, und sein Volumen dabei vergrößern. Ein Schrumpfen oder Schwinden, insbesondere eine Volumenverringerung des Duroplasts während des Aushärtens, kann so wenigstens teilweise oder vollständig kompensiert werden. Die so unter Beibehaltung des Volumens aushärtende Mold-Masse kann so spaltfrei gegen den Thermoplastrahmen anschließen. Die Mold-Masse kann in einer anderen Ausführungsform ausgebildet sein, mittels des eingeschlossenen Thermoplast beim Aushärten ihr Volumen zu vergrößern, und so gegen den Thermoplastrahmen zu pressen. Vorteilhaft kann die Mold-Masse so gegen den Thermoplastrahmen sehr gut abdichten.

In einer bevorzugten Ausführungsform weist das Expansionsmittel, insbesondere der in der Mold-Masse eingeschlossene Thermoplast, wenigstens ein Polyolefin auf. Das Polyolefin ist beispielsweise Polyethylen oder Polypropylen. Der Thermoplast, der in der Mold-Masse eingeschlossen ist, kann in einer anderen Ausführungsform, oder gemeinsam mit dem wenigstens einen Polyolefin, PET (PET = Poly-Ethylen-Terephtalat) oder Polycarbonat aufweisen.

Bevorzugt beträgt ein Anteil des Expansionsmittels in der Moldmasse zwischen 0,1 und 30 Gewichts-Prozent. Das Expansionsmittel ist bevorzugt ein Thermoplast, insbesondere Styrol, ein thermoplastisches Vinylpolymer, bevorzugt Vinylester. Weitere Beispiele für Expansionsmittel sind Vinylpolymere, beispielsweise Copolymerisate von Vinylestern, insbesondere Vinylacetat oder Vinylpropionat, Vinylpolymere mit ungesättigten organischen Säuren, insbesondere Crotonsäure, Acrylsäure, Methacrylsäure, Maleinsäure, Maleinsäurehalbestern und Vinylsulfonsäuren.

In einer vorteilhaften Ausführungsform umfassen die Expansionsmittel wenigstens ein Copolymerisat von anderen Vinylmonomeren, insbesondere Vinylpyrrolidon, Vinylcaprolactam, Methylmethacrylat, Butylacrylat oder Styrol mit ungesättigten Säuren.

Weitere Beispiele für Expansionsmittel sind Block- oder Pfropfcopolymerisate von thermoplastischen Vinylpolymeren mit den genannten ungesättigten Säuren, sowie teilweise hydrolysierte Polyvinylester. Die Vinylpolymere können nach üblichen Verfahren durch radikalische Polymerisation in Masse, Lösung, wässriger Suspension oder Emulsion erzeugt werden.

In einer bevorzugten Ausführungsform umfasst der Thermoplastrahmen PES (PES = Poly-Ether-Sulfon oder PEK (PEK = Polyether-Ether-Keton). Vorteilhaft kann so der Thermoplastrahmen temperaturstabil ausgebildet sein, und beim Gefülltwerden mit Mold-Masse in dem Spritzgusswerkzeug nicht beschädigt oder aufgeschmolzen werden.

In einer bevorzugten Ausführungsform weist die Mold-Masse Füllpartikel auf. Die Füllpartikel sind bevorzugt keramische Füllpartikel. Die keramischen Füllpartikel sind beispielsweise ausgewählt oder kombiniert aus einem Oxid, insbesondere Aluminiumoxid, oder ein Nitrid, beispielsweise Bornitrid, oder ein Karbid, beispielsweise Siliziumkarbid.
Die Mold-Masse kann so vorteilhaft gut wärmeleitfähig ausgebildet sein.

In einer bevorzugten Ausführungsform weist das Mold-Modul einen Schaltungsträger auf. Der Thermoplastrahmen umschließt den Schaltungsträger derart, dass ein von dem Thermoplastrahmen umschlossener Hohlraum gebildet ist, in dem der Schaltungsträger aufgenommen ist. Bevorzugt ist der von dem Thermoplastrahmen umschlossene Hohlraum mit der Moldmasse gefüllt, so dass der Schaltungsträger in der Moldmasse eingebettet ist.

Vorteilhaft kann das Mold-Modul so dicht und aufwandsgünstig bereitgestellt werden. Die Erfindung betrifft auch einen Getriebesensor zum Erfassen eines Magnetfelds, insbesondere eines Magnetfelds eines Permanentmagneten. Der Getriebesensor umfasst bevorzugt ein Mold-Modul gemäß der vorbeschriebenen Art. Bevorzugt weist der Schaltungsträger einen Magnetfeldsensor, insbesondere Hall-Sensor, XMR-Sensor, AMR-Sensor (AMR = Anisotrope-Magneo-Resistive) oder GMR-Sensor (GMR = Giant-Magneto-Resistive) auf. Der Magnetfeldsensor ist ausgebildet, ein durch die Mold-Masse tretendes Magnetfeld, insbesondere ein von einem Permanentmagnet erzeugtes Magnetfeld, zu erfassen und ein Sensorsignal zu erzeugen, das das Magnetfeld repräsentiert. Vorteilhaft kann der Getriebesensor so nicht durch eintretendes Getriebeöl beschädigt werden.

Die Erfindung betrifft auch ein Verfahren zum Erzeugen eines Mold-Moduls. Bei dem Verfahren wird ein mit einem Thermoplastrahmen umschlossener Schaltungsträger mit Mold-Masse gefüllt. Die Mold-Masse weist bevorzugt einen Duroplast, insbesondere ein UP-Harz als Matrixmaterial, und einen Thermoplast, insbesondere als Additiv, auf. Der Thermoplast ist ausgebildet, ein Schrumpfen oder Schwinden der Mold-Masse beim Aushärten, insbesondere Vernetzen, durch Expansion in dem aushärtenden Duroplast, durch Expandieren beim Erwärmtwerden wenigstens teilweise oder vollständig zu kompensieren, sodass die Mold-Masse gegen den Thermoplastrahmen pressen kann und gegen diesen mediendicht, insbesondere gegen Getriebeöl, abdichten kann. Bevorzugt ist der Duroplast, insbesondere ein Matrixmaterial des Duroplasts, durch ein Polyesterharz, insbesondere UP-Harz, gebildet.

Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen beschriebenen Merkmalen.

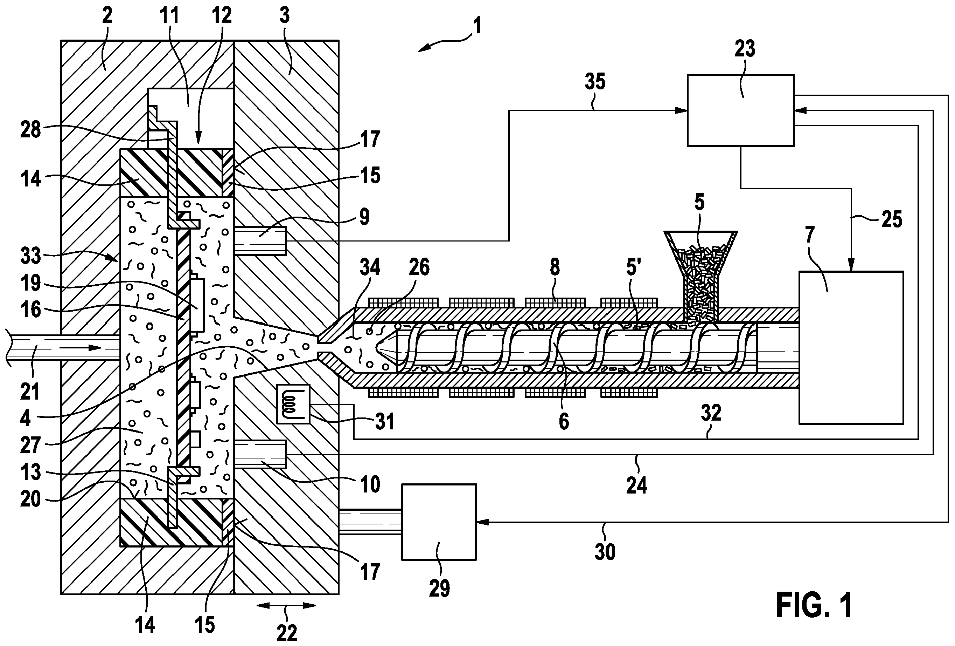

Figur 1 zeigt - schematisch - ein Ausführungsbeispiel für eine Mold-Vorrichtung, welche ausgebildet ist, ein Moldmodul zu erzeugen, bei dem eine Moldmasse spaltfrei an einen Thermoplastrahmen anschließt.

Figur 1 zeigt ein Ausführungsbeispiel für eine Mold-Vorrichtung 1. Die Mold-Vorrichtung 1 weist eine Werkzeughälfte 2 auf, welche einen Hohlraum 11 zum Aufnehmen eines Thermoplastrahmens 12 aufweist. Die Mold-Vorrichtung 1 weist auch eine weitere Werkzeughälfte 3 auf, welche einen Angusskanal 4 zum Durchführen einer geschmolzenen Mold-Masse 5' aufweist. Die Mold-Vorrichtung 1 weist auch eine Förderschnecke 6 auf, welche mit einem elektrischen Antriebsmotor 7 gekoppelt ist.

Die Mold-Vorrichtung 1 weist auch eine Heizvorrichtung 8 auf, welche ausgebildet ist, insbesondere teigförmige Mold-Masse 5 zu erzeugen, und der Förderschnecke 6 zuzuführen. Die von der Förderschnecke 6 geförderte, insbesondere teigförmige Mold-Masse 5' kann durch den Angusskanal der weiteren Werkzeughälfte 3 in den Hohlraum 11 gelangen.

In dem Hohlraum 11 ist in diesem Ausführungsbeispiel ein Thermoplastrahmen 12 aufgenommen. Der Thermoplastrahmen 12 weist eine umlaufende Wand 14 auf. In einem von dem Thermoplastrahmen 12 umschlossenen Hohlraum 27 ist in diesem Ausführungsbeispiel ein Schaltungsträger 16 angeordnet. Mit dem Schaltungsträger 16 ist in diesem Beispiel ein Magnetfeldsensor 19 lötverbunden. Mit dem Schaltungsträger 16 sind auch elektrische Anschlüsse 28 und Haltedrähte verbunden. Der Schaltungsträger ist mit den Anschlüssen 28 und mit den Haltedrähten 13 in dem Thermoplastrahmen 12 befestigt. Die Anschlüsse 28 ragen aus dem Thermoplastrahmen 12 heraus und können dort elektrisch kontaktiert werden. Die Haltedrähte 13 und die Anschlüsse 28 sind dabei mit einem Längsabschnitt in den Thermoplastrahmen 12 eingespritzt.

Der Thermoplastrahmen 12 umfasst in diesem Ausführungsbeispiel einen Rand 15, welcher eine umlaufende Auflagefläche 17 aufweist. Die Auflagefläche 17 bildet so einen Kragen oder einen Ring, gegen den die weitere Werkzeughälfte 3 abdichten kann. Der Rand 15 kann an den Thermoplastrahmen, insbesondere die Wand 14, angeformt oder angespritzt sein. Der Rand 15 kann dazu beispielsweise aus einem anderen, insbesondere weicheren Thermoplastmaterial mit einem kleineren Elastizitätsmodul erzeugt sein als die Wand 14. Der Rand kann so gut gegen das Werkzeug abdichten, während der Thermoplastrahmen 12 druckfest beim Gefülltwerden mit Moldmasse standhalten kann. Der Rand 15 kann beispielsweise gesondertes Teil auf den Thermoplastrahmen 12 aufgesteckt werden.

Die Mold-Vorrichtung 1 umfasst in diesem Ausführungsbeispiel auch eine Steuereinheit 23, welche ausgebildet ist, den Mold-Prozess zum Erzeugen eines gemoldeten Moduls zu steuern. Die Steuereinheit ist ausgebildet, die weitere Werkzeughälfte 3 - insbesondere mittels einer Hubvorrichtung - zu öffnen oder zu schließen, was durch einen bidirektionalen Pfeil 22 angedeutet ist.

Das Mold-Modul kann gemäß einem Verfahren wie folgt erzeugt werden:
Zum Erzeugen eines Mold-Moduls mit einem Thermoplastrahmen kann der Thermoplastrahmen 12 in den Hohlraum der Werkzeughälfte 2 eingelegt werden. In dem Thermoplastrahmen 12 ist der Schaltungsträger 16 eingelegt, und so in dem Hohlraum 27 des Thermoplastrahmens aufgenommen. Die Steuereinheit 23 kann dann ein Steuersignal zum Schließen der weiteren Werkzeughälfte 3 erzeugen und dieses über eine Verbindungsleitung 30 an die Hubvorrichtung 29 senden. Die Hubvorrichtung 29 kann dann die weitere Werkzeughälfte 3 schließen. Dabei dichtet die weitere Werkzeughälfte 3 gegen den Thermoplastrahmen 12, insbesondere den Rand 15 des Thermoplastrahmens, und dort gegen die Dichtfläche 17 des Randes 15, ab. Die Steuereinheit 23 kann daraufhin ein Steuersignal zum Einschießen von geschmolzener Mold-Masse 5' in den Hohlraum 11 erzeugen, und dieses an den elektrischen Antrieb 7 senden. Die geschmolzene Mold-Masse 5' wird dann - gefördert durch die Förderschnecke 6 -durch den Angusskanal 4 in das Werkzeug, umfassend die Werkzeughälften 2 und 3, eingeschossen.

Die Werkzeughälfte 3, oder zusätzliche Werkzeughälfte 2 ist in diesem Ausführungsbeispiel beheizbar ausgebildet, und weist ein Heizelement 31 auf. Das Heizelement 31 ist über eine Verbindungsleitung 32 mit der Steuereinheit 23 verbunden. Die Steuereinheit 23 kann ein Steuersignal zum Aktivieren der Heizvorrichtung 31 über die Verbindungsleitung 32 senden, sodass nach dem Einschießen der Mold-Masse 5' die in dem Hohlraum 27 des Thermoplastrahmens 12 eingeschossene Mold-Masse nachgeheizt werden kann.

Die Mold-Masse 5' umfasst in diesem Ausführungsbeispiel einen Duroplast 34 als Matrixmaterial und einen Thermoplastanteil 26, insbesondere Styrol. Der Thermoplastanteil kann als Partikel, Faser oder flüssig in der verflüssigten Moldmasse 5' enthalten sein.

Der Thermoplastanteil 26 wird zusammen mit der verflüssigten Mold-Masse 5' in das Mold-Werkzeug eingeschossen, und wird dort erst beim Nachheizen aushärten. Die in das Mold-Werkzeug eingeschossene Mold-Masse kann dann in dem Thermoplastrahmen 12 expandieren. So kann einem Schrumpfprozess der aushärtenden Mold-Masse 5' entgegengewirkt werden. Die in dem Hohlraum 27 des Thermoplastrahmens 12 aufgenommene Mold-Masse 5' kann dann gegen eine Innenwand 20 des Thermoplastrahmens 12 fest anpressen, und so gegen den Thermoplastrahmen 12 abdichten.

Die weitere Werkzeughälfte 3 weist in diesem Ausführungsbeispiel auch einen Temperatursensor 9 und einen Drucksensor 10 auf. Der Temperatursensor 9 ist ausgebildet, ein Temperatursignal zu erzeugen, und dieses über eine Verbindungsleitung 35 an die Steuereinheit 3 zu senden. Die Steuereinheit 3 kann so die Temperatur der Mold-Masse beim Aushärten überwachen. Der Temperatursensor ist beispielsweise ein NTC-Widerstandssensor (NTC = Negative-Temperature-Coefficient). Die weitere Werkzeughälfte 3 weist auch einen Drucksensor 10 auf, welcher ausgebildet ist, einen Druck der Mold-Masse, insbesondere in dem Hohlraum 27, zu erfassen und ein den erfassten Druck repräsentierendes Drucksignal zu erzeugen und über eine Verbindungsleitung 24 an die Steuereinheit 23 zu senden. Die Steuereinheit 23 ist ausgebildet, in Abhängigkeit des Temperatursignals und des Drucksignals ein Zeitintervall zum Schließen oder zum Öffnen der weiteren Werkzeughälfte 3 zu erzeugen. Die weitere Werkzeughälfte 3 kann so in Abhängigkeit des Zeitintervalls, insbesondere nach dessen Ablauf, durch die Hubvorrichtung 29 geöffnet werden. Nach dem Öffnen der weiteren Werkzeughälfte 23 kann das so fertig gemoldete Mold-Modul 33 durch eine Ausstoßvorrichtung 21 aus der Werkzeughälfte 2 ausgestoßen werden.

## Patentansprüche

1. Moldmodul (33) umfassend ein Halbleiterbauteil (19), wobei das Halbleiterbauteil (19) in Moldmasse (5) eingebettet ist,
**dadurch gekennzeichnet, dass**
das Moldmodul (33) einen die Moldmasse (5) umspannenden Rahmen (12) umfassend einen Thermoplast aufweist,
und die Moldmasse (5) einen Duroplast (34) und eine Expansionskomponete (26) umfasst, wobei die Expansionskomponente (26) in dem Duroplast (24) eingemischt oder eingebettet ist und ausgebildet ist, ein Schwinden, insbesondere eine Volumenverringerung des Duroplasts (34) zu kompensieren und so gegen den Rahmen (12) abzudichten.

2. Moldmodul (33) nach Anspruch 1,
**dadurch gekennzeichnet, dass**
die Expansionskomponente (26) ein Thermoplast ist, der in dem Duroplast (34), insbesondere homogen verteilt ist.

3. Moldmodul (33) nach Anspruch 1,
**dadurch gekennzeichnet, dass**
in der Moldmasse (5) Thermoplastpartikel (26) oder Thermoplastfasern (26) eingebettet sind.

4. Moldmodul (33) nach einem der vorhergehenden Ansprüche,
**dadurch gekennzeichnet, dass**
die Expansionskomponente (26) Styrol oder Polystyrol aufweist.

5. Moldmodul (33) nach einem der vorhergehenden Ansprüche,
**dadurch gekennzeichnet, dass**
die Expansionskomponente (26) wenigstens ein Polyolefin aufweist.

6. Moldmodul (33) nach einem der vorhergehenden Ansprüche,
**dadurch gekennzeichnet, dass**
die Moldmasse (5) als Duroplast ein Polyesterharz aufweist.

7. Moldmodul (33) nach einem der vorhergehenden Ansprüche,
**dadurch gekennzeichnet, dass**
der Thermoplastrahmen (12) Poly-Ether-Sulfon oder Poly-Ether-Ether-Keton umfasst.

8. Moldmodul (33) nach einem der vorhergehenden Ansprüche,
**dadurch gekennzeichnet, dass**
die Moldmasse (5) Keramikpartikel aufweist.

9. Moldmodul (33) nach einem der vorhergehenden Ansprüche,
**dadurch gekennzeichnet, dass**
das Moldmodul (33) einen Schaltungsträger (16) aufweist, und der Thermoplastrahmen (12) den Schaltungsträger (16) derart umschließt, dass ein von dem Thermoplastrahmen umschlossener Hohlraum gebildet ist, in dem der Schaltungsträger (12) aufgenommen ist, wobei der von dem Thermoplastrahmen (12) umschlossene Hohlraum (27) mit der Moldmasse (5) gefüllt ist, in die der Schaltungsträger (16) eingebettet ist.

10. Getriebesensor zum Erfassen eines Magnetfelds umfassend ein Moldmodul (33) gemäß einem der vorhergehenden Ansprüche 1 bis 8,
**dadurch gekennzeichnet, dass**
der Schaltungsträger (16) einen Magnetfeldsensor (19), insbesondere Hallsensor, XMR-Sensor, AMR-Sensor oder GMR-Sensor aufweist, welcher ausgebildet ist, ein durch die Moldmasse tretendes Magnetfeld zu erfassen.

11. Verfahren zum Erzeugen eines Moldmoduls (33), bei dem ein mit einem Thermoplastrahmen (12) umschlossener Schaltungsträger (16) mit Moldmasse (5) gefüllt wird, wobei
die Moldmasse (5) einen Duroplast (34) als Matrixmaterial und einen Thermoplast (26) als Additiv aufweist, wobei der Thermoplast (26) ausgebildet ist, ein Schrumpfen der Moldmasse (5) beim Aushärten, insbesondere Vernetzen, durch Expansion in dem aushärtenden Duroplast (5'), insbesondere Polyesterharz, durch Expandieren beim Erwärmtwerden zu zu kompensieren, so dass die Moldmasse (5) gegen den Thermoplastrahmen (12) pressen kann und gegen diesen mediendicht, insbesondere gegen Getriebeöl, abdichten kann.
